# EUROPEAN PATENT SPECIFICATION

(11) **EP 2 273 314 B1**
(45) Date of publication and mention of the grant of the patent: **25.07.2012**
(21) Application number: 09722561.9
(22) Date of filing: 16.03.2009
(51) Int. Cl.: G03F 7/004, G03F 7/038, H01L 21/027

(54) **PHOTOSENSITIVE RESIN COMPOSITION, FILM FOR PHOTOSENSITIVE RESIN SPACER, AND SEMICONDUCTOR DEVICE**
LICHTEMPFINDLICHE HARZZUSAMMENSETZUNG, FILM FÜR EINE LICHTEMPFINDLICHE HARZABSTANDSSCHICHT UND HALBLEITERANORDNUNG
COMPOSITION DE RÉSINE PHOTOSENSIBLE, FILM POUR INTERCALAIRE EN RÉSINE PHOTOSENSIBLE, ET DISPOSITIF SEMI-CONDUCTEUR

(30) Priority: 18.03.2008 JP 2008069305
(43) Date of publication of application: 12.01.2011
(73) Proprietor: Sumitomo Bakelite Company Limited, Shinagawa-ku Tokyo 140-0002 (JP)
(72) Inventor: SHIRAISHI, Fumihiro, Tokyo 140-0002 (JP); TAKAHASHI, Toyosei, Tokyo 140-0002 (JP)
(74) Representative: Müller, Christian Stefan Gerd
(86) International application number: PCT/JP2009/001151
(87) International publication number: WO 2009/116258

(56) References cited:
- EP-A1- 2 154 205
- JP-A- 5 188 593
- JP-A- 2003 114 528
- JP-A- 2003 316 001
- JP-A- 2005 062 621
- JP-A- 2005 084 114
- JP-A- 2006 016 610
- JP-A- 2007 182 530
- US-B1- 6 534 235

## Description

### TECHNICAL FIELD

The present invention relates to a photosensitive resin composition, a film for a photosensitive resin spacer and a semiconductor device.

### BACKGROUND ART

In recent years, there has been required a photosensitive film which can be bonded to a semiconductor wafer or the like to form a pattern by exposure to light and development, and then bonded to a transparent substrate such as a glass or the like (e.g., refer to Patent Document 1). In this case, the patterned photosensitive film has behavior of a spacer between the semiconductor wafer and the transparent substrate.

A resin composition used to form this spacer has been required to allow patterning by a photolithographic process, and maintain the shape as a spacer as well.
Furthermore, when a semiconductor wafer and a transparent substrate are aligned and bonded to each other, alignment marks of the semiconductor wafer or the transparent substrate are needed to be recognized through the photosensitive film, so that transparency has been required for the photosensitive film.

Patent Document 1: Japanese Patent Laid-open No. 2006-323089
Photosensitive Resin Compositions containing in organic filler are already known from EP-A-2154205 document in the sense of a Art 54(3)EPC and from US-A-6534235, JP2005062621, JP2006016610, JP2003-114528.

### DISCLOSURE OF THE INVENTION

An object of the present invention is to provide a photosensitive resin composition which is excellent in shape retention function as a photosensitive resin spacer, has a small residue of the photosensitive resin composition after exposure to light and development, and is excellent also in tack properties, and a film for a photosensitive resin spacer using the photosensitive resin composition.
Furthermore, another object of the present invention is to provide a highly reliable semiconductor device, wherein a semiconductor element and a substrate are bonded to each other via a photosensitive resin spacer composed of a cured material of the above-described photosensitive resin composition.

The above objects can be attained according to the present invention as set forth in the following [1] to [21].
[1] A photosensitive resin composition used as a resin spacer for forming a cavity section between a substrate and a semiconductor element, including (A) an alkali-soluble resin, (B) a photopolymerizable resin, (C) a filler, (D) a photosensitizing agent, and (E) a thermosetting resin different from said alkali-soluble resin, wherein the average particle diameter of said filler is in the range of 5 to 25 nm and the content of said filler is in the range of 1 to 15 weight % of the total photosensitive resin composition.
[2] The photosensitive resin composition according to [1], wherein said filler contains silica.
[3] The photosensitive resin composition according to [1], wherein said alkali-soluble resin is a resin having an alkali-soluble group and a double bond.
[4] The photosensitive resin composition according to [1], wherein the content of (A) said alkali-soluble resin is in the range of 50 to 95 weight % of the total photosensitive resin composition, the content of (B) said photopolymerizable resin is in the range of 5 to 45 weight % of the total photosensitive resin composition, and the content of (D) said photosensitizing agent is in the range of 0.1 to 10 weight % of the total photosensitive resin composition.
[5] The photosensitive resin composition according to [1], wherein the content of (E) said thermosetting resin is in the range of 5 to 30 weight % of the total photosensitive resin composition.
[6] A film for a photosensitive resin spacer composed of the photosensitive resin composition according to [1].
[7] The film for a photosensitive resin spacer according to [6] , wherein the transmittance at a wavelength of 400 nm is not less than 40%, the transmittance at a wavelength of 550 nm is not less than 65%, and the transmittance at a wavelength of 750 nm is not less than 73%.
[8] The film for a photosensitive resin spacer according to [6] , wherein the tackiness of said film for a resin spacer at 40°C is not more than 40 gf.
[9] The film for a photosensitive resin spacer according to [6], wherein the elastic modulus of said film for a resin spacer at 260°C is not less than 20 MPa.
[10] The film for a photosensitive resin spacer according to [6], wherein the thickness of said film for a photosensitive resin spacer is in the range of 20 to 150 µm.
[11] A semiconductor device, wherein a substrate and a semiconductor element are bonded to each other through a resin spacer composed of a cured material of the photosensitive resin composition according to [1].

According to the present invention, it is possible to provide a photosensitive resin composition which is excellent in shape retention function as a photosensitive resin spacer, has a small residue of the photosensitive resin composition after exposure to light and development, and is excellent also in tack properties, and a film for a resin spacer using the photosensitive resin composition.
Furthermore, according to the present invention, it is possible to provide a highly reliable semiconductor device, wherein a semiconductor element and a substrate are bonded to each other via a photosensitive resin spacer composed of a cured material of the above-described photosensitive resin composition.

### BRIEF DESCRIPTION OF THE DRAWINGS

The above and other objects, features and advantages will be apparent from the following detailed description of the preferred embodiments in conjunction with the accompanying drawings.
Fig. 1 is a cross-sectional view illustrating one embodiment of a semiconductor device.
Fig. 2 is a cross-sectional view schematically illustrating a process for producing the semiconductor device.
Fig. 3 is a cross-sectional view illustrating another embodiment of the semiconductor device.

### BEST MODE FOR CARRYING OUT THE INVENTION

Hereinafter, the photosensitive resin composition, the film for a photosensitive resin spacer and the semiconductor device of the present invention will be described in more detail.
The photosensitive resin composition of the present invention which is used as a resin spacer for forming a cavity section between a substrate and a semiconductor element contains (A) an alkali-soluble resin, (B) a photopolymerizable resin, (C) a filler, (D) a photosensitizing agent and (E) a thermosetting resin different from said alkali-soluble resin. The average particle diameter of (C) the above-described filler is in the range of 5 to 25 nm, and the content of the above-described filler is in the range of 1 to 15 weight % of the total photosensitive resin composition (hereinafter "in the range of - to ∼"means the upper limit value and the lower limit value (inclusive) unless otherwise particularly specified).
Furthermore, for the semiconductor device of the present invention, a substrate and a semiconductor element are bonded to each other via a photosensitive resin spacer composed of a cured material of the above-described photosensitive resin composition.

### 1. Photosensitive Resin Composition and Film for Photosensitive Resin Spacer

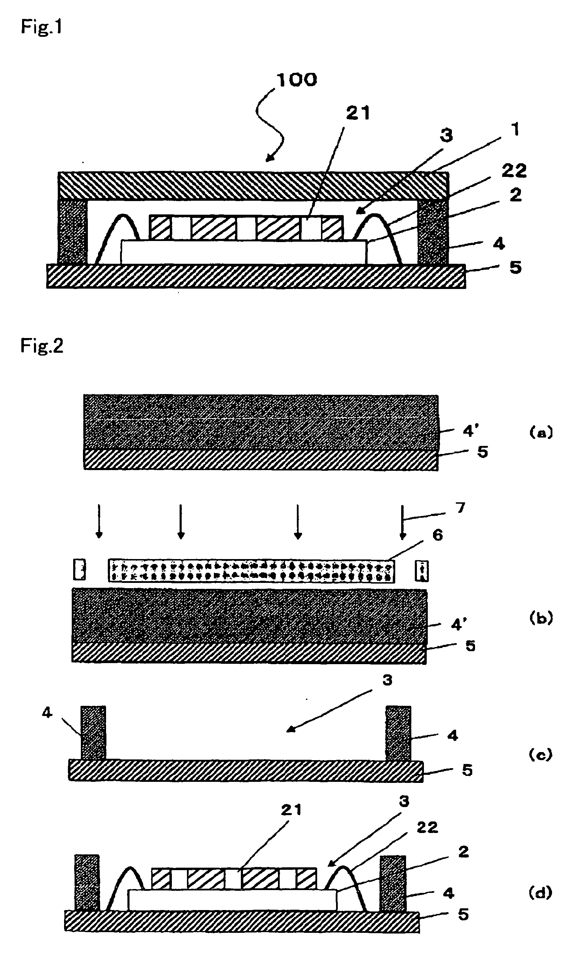

First, the photosensitive resin composition and the film for a photosensitive resin spacer will be illustrated below.
The photosensitive resin composition of the present invention is used as a photosensitive resin spacer 4 for forming a cavity section 3 between a substrate 1 and a semiconductor element 2 of a semiconductor device 100 as shown in Fig. 1.
This photosensitive resin composition contains (A) an alkali-soluble resin, (B) a photo polymerizable resin, (C) a filler (D) a photosensitizing agent and (E) a thermosetting resin different from said alkali-soluble resin. The average particle diameter of the above-described filler is in the range of 5 to 25 nm, and the content of the above described filler is in the range of 1 to 15 weight % of the total photosensitive resin composition. Accordingly, the photosensitive resin composition is excellent in shape retention function of a photosensitive resin spacer, has a small residue of the photosensitive resin composition after exposure to light and development, and is excellent also in tack properties.

The above-described photosensitive resin composition contains (A) an alkali-soluble resin. Accordingly, alkali development can be carried out. Examples of (A) the above-described alkali-soluble resin include, for example, a phenol novolac resin such as such as cresol, phenol, bisphenol A, bisphenol F, catechol, resorcinol, pyrogallol and the like; an acrylic resin such as a phenol aralkyl resin, a hydroxystyrene resin, a methacrylate resin, a methacrylate ester resin and the like; a cyclic olefin resin having a hydroxyl group, a carboxyl group and the like; a polyamide resin (specifically, a resin having at least one of a polybenzoxazole structure and a polyimide structure, and having a hydroxyl group, a carboxyl group, an ether group or an ester group in the main chain or side chain; a resin having a polybenzoxazole precursor structure; a resin having a polyimide precursor structure; and a resin having a polyamic acid ester structure) and the like.

Meanwhile, a more preferred examples of (A) the above-described alkali-soluble resin includes a resin having an alkali-soluble group and a double bond. By applying a resin having an alkali-soluble group and a double bond, it is possible to combine excellent shape retention function as a photosensitive resin spacer and further developability during development.

Herein, the content of (A) the alkali-soluble resin is not particularly limited, but it is preferably in the range of 50 to 95 weight % and particularly preferably in the range of 55 to 90 weight % of the total photosensitive resin composition. In particular, it may be in the range of 10 to 90 weight % and preferably in the range of 15 to 80 weight % of the resin components of the photosensitive resin composition (all components excluding the filler). When the content of (A) the alkali-soluble resin is less than the lower limit value noted above, the effect of improving the miscibility between a photocurable resin and a thermosetting resin is decreased in some cases, and shape retention properties of the photosensitive resin spacer when the semiconductor element and the substrate are attached by thermal bonding are reduced in some cases. In addition, when it exceeds the upper limit value noted above, developability and patterning resolution of an adhesive layer by a photolithographic technique are deteriorated in some cases. The content of (A) the alkali-soluble resin and the amount of liquid components in the photosensitive resin composition are in the above ranges, so that it is possible to have a function of allowing thermal bonding after the resin is patterned by a photolithographic process.

The alkali-soluble group is present in (A) the above-described alkali-soluble resin, so that it is possible to carry out development with an alkali aqueous solution which causes less load to the environment during development. Also, the double bond is present in (A) the above-described alkali-soluble resin, so that (A) the alkali-soluble resin is crosslinked during exposure to light, and thus shape retention properties of the photosensitive resin spacer are excellent. Furthermore, the unreacted double bond during exposure to light is further crosslinked owing to heat history after development and lamination of the substrate and the semiconductor element, so that heat resistance of the photosensitive resin spacer can be improved.

The above-described alkali-soluble group is not particularly limited, but examples thereof include, for example, a hydroxyl group, a carboxyl group and the like. This alkali-soluble group can also contribute to a thermal curing reaction.
Meanwhile, the double bond is not particularly limited, but examples thereof include, for example, a (meth)acryloyl group, a vinyl group, an allyl group and the like.
Furthermore, the resin having an alkali-soluble group and a double bond may have a thermally reactive group such as an epoxy group, an amino group, a cyanate group and the like. Specific examples of the above-described resin having an alkali-soluble group and a double bond include a (meth)acryloyl modified phenol resin, an acrylic acid polymer having a (meth)acryloyl group, an epoxy (meth)acrylate resin having a carboxyl group and the like.
Among such resins, preferably used is a (meth)acryloyl modified phenol resin which is excellent in shape retention function as a photosensitive resin spacer, and has a small residue of the photosensitive resin composition after exposure to light and development.

The resin having an alkali-soluble group and a double bond is not particularly limited, but it can be obtained, for example, by introducing a compound having a double bond into a resin having a hydroxyl group and/or a carboxyl group.
Specifically, such resins can be obtained by the reaction between a part of a hydroxyl group and/or a carboxyl group of a resin having a hydroxyl group and/or a carboxyl group, and a compound having an epoxy group and a (meth)acrylic group, or the reaction between a part of a carboxyl group of a resin having a carboxyl group, and a compound having a hydroxyl group and a (meth)acrylic group. More specifically, such resins can be obtained by the reaction between a phenol resin and glycidyl (meth)acrylate or the reaction between a resin having a carboxyl group and hydroxyalkyl (meth)acrylate.

In addition, the resin having an alkali-soluble group and a double bond is not particularly limited, but such resins can also be obtained, for example, by introducing a compound having a hydroxyl group and/or a carboxyl group into a resin having a double bond.

Herein, when a compound having a double bond is introduced into a resin having a hydroxyl group and/or a carboxyl group, the modification rate of the hydroxyl group and/or the carboxyl group is not particularly limited, but it is preferably in the range of 20 to 80% and particularly preferably in the range of 30 to 70% of the total hydroxyl group and/or carboxyl group. The modification rate is provided within the above range, so that it is possible in particular to achieve shape retention function as a photosensitive resin spacer and to suppress the residue of the photosensitive resin composition after exposure to light and development at the same time.

In addition, when a compound having a hydroxyl group and/or a carboxyl group is introduced into a resin having a double bond, the modification rate is preferably in the range of 20 to 80% and particularly preferably in the range of 30 to 70% of the total reactive groups. The modification rate of the compound having a hydroxyl group and/or a carboxyl group is provided within the above range, so that it is possible in particular to achieve shape retention function as a resin spacer and to suppress the residue of the photosensitive resin composition after exposure to light and development at the same time.

The weight average molecular weight of the above-described resin having an alkali-soluble group and a double bond is not particularly limited, but it is preferably not more than 30,000 and particularly preferably in the range of 5,000 to 15,000. When the weight average molecular weight is within the above range, the film for a photosensitive resin spacer is particularly excellent in film-forming properties.
Here, the weight average molecular weight can be evaluated, for example, by using G.P.C., and the weight average molecular weight can be calculated by a calibration curve prepared in advance by use of a styrene standard substance. Incidentally, it is measured using tetrahydrofuran (THF) as a measurement solvent under a temperature condition of 40°C.

The above-described photosensitive resin composition contains (B) a photopolymerizable resin. Accordingly, it is possible to further improve patterning properties and shape retention function of the resin spacer during bonding of the semiconductor element and the substrate by thermal bonding along with (A) the above-described alkali-soluble resin.
Examples of (B) the above-described photopolymerizable resin include, for example, unsaturated polyester, an acrylic compound such as a (meth) acrylic monomer or an oligomer having at least one or more acryloyl groups or methacryloyl groups in one molecule and the like, a vinyl compound such as styrene, and the like. These compounds can be used singly or two or more kinds can also be used in combination.

Among these compounds, preferably used is (B) a photopolymerizable resin having an acrylic compound as a main ingredient. The reason is that the curing rate of the acrylic compound is fast during an irradiation with light, so that the photosensitive resin composition can be patterned with a relatively small amount of exposure to light.

The above acrylic compound is not limited, but examples thereof include, for example, (meth)acrylic acid adduct of polyalkylene glycol such as, polyethylene glycol di(meth)acrylate, polypropylene glycol di(meth)acrylate, polybutylene glycol di(meth)acrylate or the like, (meth)acrylic acid adduct of bifunctional polyalkylene glycol such as 1,6-hexanediol di(meth)acrylate, glycerine di(meth)acrylate, 1,10-decanediol di(meth)acrylate and the like; and polyfunctional (meth)acrylate such as trimethylolpropane tri(meth)acrylate, pentaerythritol tri(meth)acrylate, dipentaerythritol hexa(meth)acrylate and the like.
Among these compounds, preferably used is (meth)acrylic acid adduct of polyalkylene glycol. Among these compounds, particularly preferably used are polyethylene glycol di(meth)acrylate, polypropylene glycol di(meth)acrylate and 1,6-hexanediol di(meth)acrylate which are excellent in photoreactivity and have improved sensitivity of the photosensitive resin composition.

Furthermore, (B) the above-described photopolymerizable resin is not particularly limited, but it is preferably liquid at a normal temperature. Accordingly, the reactivity in curing by an irradiation with light (e.g., ultraviolet rays) can be improved. In addition, it is possible to mix (B) such a resin with other components (e.g., an alkali-soluble resin) with ease. Examples of the photopolymerizable resin which is liquid at a normal temperature include the photopolymerizable resin having an acrylic compound described above as a main ingredient and the like.

The weight average molecular weight of (B) the above-described photopolymerizable resin is not particularly limited, but it is preferably not more than 5,000 and particularly preferably in the range of 150 to 3,000. When the weight average molecular weight is within the above range, it is particularly excellent in the sensitivity of the film for a photosensitive resin spacer. Furthermore, it is also excellent in the resolution of the film for a resin spacer.
Here, the weight average molecular weight can be evaluated, for example, by using G.P.C., and the weight average molecular weight can be calculated by a calibration curve prepared in advance by use of a styrene standard substance. Incidentally, it is measured using tetrahydrofuran (THF) as a measurement solvent under a temperature condition of 40°C.

Herein, the content of (B) the above-described photopolymerizable resin is not particularly limited, but it is preferably in the range of 5 to 45 weight % and particularly preferably in the range of 7 to 40 weight % of the total photosensitive resin composition. In particular, the content is not less that 10 weight % and preferably not less than 15 weight % of the resin components of the photosensitive resin composition (all components excluding the filler).
When the content of (B) the above-described photopolymerizable resin exceeds the upper limit value noted above, heat resistance of the photosensitive resin composition is damaged in some cases. Also, when the content of (B) the above-described photopolymerizable resin is less than the lower limit value noted above, flexibility is damaged in some cases, and patterning of the photosensitive resin composition by an irradiation with light is not sufficiently carried out in some cases. Therefore, the content of (B) the above photopolymerizable resin is provided in the above range, so that it is possible to provide a photosensitive resin composition which is excellent in balancing both properties, for example, without damaging a balance between heat resistance and flexibility, and is particularly excellent in peeling properties of a protective film or the like which is applied to a film for a photosensitive resin spacer.

The above photosensitive resin composition contains (C) a filler that is granular. The average particle diameter of (C) the above-described filler is in the range of 5 to 25 nm and the content of the (C) the above-described filler is in the range of 1 to 15 weight %. Accordingly, the photosensitive resin composition is excellent in shape retention function as a photosensitive resin spacer, has a small variation in the height of the photosensitive resin spacer, is excellent in the fluidity of the photosensitive resin composition, has a small residue of the photosensitive resin composition after exposure to light and development, and is excellent in recognition properties of the alignment mark of the semiconductor element or the substrate, and is excellent also in tack properties of the film for a photosensitive resin spacer.
Here, the average particle diameter of (C) the filler is measured by dispersing (C) the filler in water and using a laser diffraction particle size distribution meter (SALD-7000). Measurement is started after the ultrasonic treatment is carried out for one minute.

When the average particle diameter of (C) the above filler is smaller than 5 nm, it is possible to secure shape retention function of the photosensitive resin spacer in a small amount, whereas (C) the filler is agglomerated in the photosensitive resin composition, thereby causing a variation in the height of the photosensitive resin spacer during the formation of the photosensitive resin spacer and failing to joint the substrate with the semiconductor element in some cases. On the other hand, when the average particle diameter is higher than 25 nm, the amount of (C) the filler added needs to be higher than 15 weight % in order to exhibit shape retention properties of the photosensitive resin spacer, so that the fluidity of the photosensitive resin composition is deteriorated during the joint of the substrate and the semiconductor element for causing bad joint, lots of residues of the photosensitive resin composition after the development are caused, and recognition properties of alignment marks of the semiconductor element and the substrate are deteriorated in some cases.

The lower limit of the average particle diameter of (C) the filler is not less than 5 nm, preferably not less than 7 nm and more preferably not less than 9 nm. The upper limit of the average particle diameter of (C) the filler is not more than 25 nm, preferably mot more than 23 nm and more preferably not more than 20 nm. In addition, the lower limit of the content of (C) the filler is not less than 1 weight %, preferably not less than 2 weight % and more preferably not less than 3 weight %. The upper limit of the content of (C) the filler is not more than 15 weight %, preferably not more than 14 weight % and more preferably not more than 12 weight %.
Within the above ranges, it is possible to secure an excellent balance in shape retention properties of the resin spacer, reduction of a variation in the height of the resin spacer, fluidity of the resin composition, decrease of the residue of the resin composition after development and further recognition properties of the alignment mark of the semiconductor element or the substrate. In particular, within the above ranges, it is possible to achieve both developability and shape retention properties.

Examples of such (C) a filler include, for example, organic fillers such as a phenol resin, an acrylic resin, polyamide, polysulfone, polystyrene, a fluorine resin and the like, and inorganic fillers to be described below. Of these fillers, preferably used are inorganic fillers. Accordingly, it is possible to improve heat resistance, dimensional stability, moisture resistance and the like: In addition, it is possible to improve peeling properties of a protective film which is used as a film for a photosensitive resin spacer.

Examples of the above-described inorganic filler include, for example, silicate such as talc, calcined clay, uncalcined clay, mica, glass and the like; oxide of silica powder such as titanium dioxide, alumina, fused silica (spherical fused silica, crushed fused silica), crystalline silica and the like; carbonate such as calcium carbonate, magnesium carbonate, hydrotalcite and the like; hydroxide such as aluminum hydroxide, magnesium hydroxide, calcium hydroxide and the like; sulfate and sulfite such as barium sulfate, calcium sulfate, calcium sulfite and the like; borate such as zinc borate, barium metaborate, aluminum borate, calcium borate, sodium borate and the like; and nitride such as aluminum nitride, boron nitride, silicon nitride and the like. These inorganic fillers may be used singly or in mixture. Of these fillers, preferably used is silica powder such as fused silica, crystalline silica and the like, and particularly preferably used is spherical fused silica.

The present invention contains (D) a photosensitizing agent. (D) The above-described photosensitizing agent is contained, whereby it is possible to provide a function of allowing patterning the film for a photosensitive resin spacer with good efficiency by photopolymerization.
(D) The above-described photosensitizing agent is not particularly limited as long as (B) the photopolymerizable resin is cured by irradiating the photosensitive resin composition or the film for a photosensitive resin spacer with rays.
Examples of such (D) a photosensitizing agent include, for example, benzophenone, acetophenone, benzoin, benzoin isobutyl ether, benzoin methyl benzoate, benzoin benzoate, benzoin methyl ether, benzylphinyl sulfide, benzyl, dibenzyl, diacetyl and the like.

The content of (D) the photosensitizing agent is not particularly limited, but it is preferably in the range of 0.1 to 10 weight % and particularly preferably in the range of 0.5 to 8 weight % of the total photosensitive resin composition. If the content of (D) the photosensitizing agent is less than the lower limit value noted above, the effect of initiating photopolymerization is deteriorated in some cases. If the content exceeds the upper limit value noted above, the reactivity of the photopolymerization becomes too great, consequently reducing storage properties and resolution after patterning of the photosensitive resin composition prior to use in some cases. Therefore, the content of (D) the photosensitizing agent is provided within the above range, so that it is possible to provide a photosensitive resin composition which is excellent in balancing both properties.

The above-described photosensitive resin composition is not particularly limited, but in addition to (A) the alkali-soluble resin, (B) the photopolymerizable resin, (C) the filler and (D) the photosensitizing agent described above, it further contains (E) the thermosetting resin.

(E) The above-described thermosetting resin (the above-described alkali-soluble resin refers to a thermosetting resin having a different resin structure) is capable of providing, for example, a function of improving heat resistance of the film for a photosensitive resin spacer.
Examples of (E) the above-described thermosetting resin include, for example, a novolac type phenol resin such as a phenol novolac resin, a cresol novolac resin, a bisphenol A novolac resin and the like; a phenol resin such as a resol phenol resin and the like; a bisphenol type epoxy resin such as a bisphenol A epoxy resin, a bisphenol F epoxy resin and the like; a novolac type epoxy resin such as a novolac epoxy resin, a cresol novolac epoxy resin and the like; an epoxy resin such as a biphenyl type epoxy resin, a stilbene type epoxy resin, a triphenolmethane type epoxy resin, an alkyl modified triphenolmethane type epoxy resin, an epoxy resin containing a triazine nucleus, a dicyclopentadiene modified phenol type epoxy resin and the like; a resin containing a triazine ring such as an urea resin, a melamine resin and the like; an unsaturated polyester resin; a bismaleimide resin; a polyurethane resin; a diallyl-phthalate resin; a silicon resin; a resin having a benzoxazine ring; a cyanate ester resin, and the like. These resins may be used singly or in mixture. Among these resins, particularly preferably used is an epoxy resin. Accordingly, it is possible to enhance heat resistance and adhesion property.

In addition, as the above-described epoxy resin, it is preferable to use a silicon modified epoxy resin, and it is preferable to use, in combination, an epoxy resin which is solid at a room temperature (especially, a bisphenol type epoxy resin) and an epoxy resin which is liquid at a room temperature (especially, a silicon modified epoxy resin which is liquid at a room temperature). Accordingly, it is possible to achieve the photosensitive resin composition which is excellent in both flexibility and resolution while maintaining heat resistance.

The content of (E) the above-described thermosetting resin is not particularly limited, but it is preferably in the range of 5 to 30 weight % and particularly preferably in the range of 10 to 25 weight % of the total photosensitive resin composition. If the content is less that the lower limit value noted above, the effect of improving heat resistance is deteriorated in some cases. If the content exceeds the upper limit value noted above, the effect of improving toughness of the photosensitive resin composition is deteriorated in some cases.

The above-described photosensitive resin composition is not particularly limited, but for the purpose of improving general properties, it may further contain an additive such as an ultraviolet absorber, a leveling agent or the like.

Such a photosensitive resin composition is mixed into a suitable organic solvent (for example, N-methyl-2-pyrrolidone, anisole, methyl ethyl ketone, toluene, ethyl acetate and the like), and the mixture is applied, for example, to a support film or the like and dried, whereby it is possible to obtain a film for a photosensitive resin spacer.

The above-described support film is not particularly limited as long as it is a film support base material which is excellent in breaking strength, flexibility and the like, and examples thereof include, for example, polyethylene terephthalate (PET), polypropylene (PP), polyethylene (PE) and the like. Among these, preferably used are polypropylene (PP) and polyethylene terephthalate (PET) which are excellent in balancing flexibility and breaking strength.

A thickness of the above-described film for a photosensitive resin spacer is almost the same as the required thickness of the resin spacer and is not particularly limited, but it is preferably in the range of 20 to 150 µm and particularly preferably in the range of 30 to 80 µm. The thickness is provided within the above range, so that it is possible to separate the distance between the light receiving section and the substrate when the resin spacer is applied to the semiconductor device having a light receiving section. Thereby, it is possible to shift a focal point so that the effect of dust or the like attached on the substrate can be reduced.

Furthermore, it is preferable that such a film for a photosensitive resin spacer satisfies the following requirements. That is, when the transmittances of the above-described film for a photosensitive resin spacer are measured under the following conditions (1) and (2), it is preferable that the transmittance at a wavelength of 400 nm is not less than 40%, the transmittance at a wavelength of 550 nm is not less than 65%, and the transmittance at a wavelength of 750 nm is not less than 73%. It is particularly preferable that the transmittance at a wavelength of 400 nm is not less than 50%, the transmittance at a wavelength of 550 nm is not less than 70%, and the transmittance at a wavelength of 750 nm is not less than 85%.
(1) Thickness of the film for a photosensitive resin spacer: 25 µm.
(2) Measurement wavelength: 200 to 1,000 nm.
Here, the above-described transmittances can be evaluated, for example, with a UV visible spectrophotometer UV-160A (model number) (a product of Shimadzu Corporation).

Here, the above-described transmittances are preferably evaluated at wavelengths of 400 nm, 550 nm and 750 nm. If the transmittances are within the above range, it is found that recognition properties are excellent when an adhesive film for a photosensitive resin spacer composed of the photosensitive resin composition of the present invention is attached to the semiconductor element or the substrate, and alignment marks of the semiconductor element and the substrate are recognized through the adhesive film for a photosensitive resin spacer at various visible lights (wavelength: 400 to 770 nm).

Furthermore, it is preferable that such a film for a photosensitive resin spacer satisfies the following requirements. That is, when the tackiness of the above-described film for a photosensitive resin spacer at 40°C is measured under the following conditions (1) to (5), the tackiness thereof is preferably not more than 40 gf and particularly preferably not more than 35 gf. If the above-described tackiness at 40°C is within the upper limit value noted above, a device is not contaminated when conveying the film for a photosensitive resin spacer, and the effect of excelling in peeling properties of a cover film when laminating the cover film with the film for a photosensitive resin spacer is further obtained. The lower limit of the tackiness at 40°C is not particularly limited, but it is preferably not less than 10 gf and particularly preferably not less than 15 gf. If the lower limit of the tackiness at 40°C is lower than the above range, adhesion property with the cover film is deteriorated and workability is lowered in some cases.
(1) Thickness of the film for a photosensitive resin spacer: 25 µm.
(2) Stamping speed: 30 mm/min.
(3) Stamping time: 1 sec.
(4) Tensile speed: 600 mm/min.
(5) Load: 80 gf.
(6) Probe-stage temperature: 40°C.

In the present invention, if the tackiness at 40°C is within the above range, it is found that, a device is not contaminated when conveying the film for a photosensitive resin spacer for laminating the film for a photosensitive resin spacer composed of the photosensitive resin composition of the present invention to the semiconductor element or the substrate without attaching to the device, and peeling properties of a cover film are further excellent when laminating the cover film to the film for a photosensitive resin spacer.
Furthermore, an atmosphere temperature for the measurement of the tackiness is determined to be 40°C, because it is easy to confirm the difference between samples.

Furthermore, it is preferable that such a film for a photosensitive resin spacer satisfies the following requirements. That is, when the elastic modulus of the above-described film for a photosensitive resin spacer at 260°C is measured under the following conditions (1) to (3), the elastic modulus is preferably not less than 20 MPa and particularly preferably not less than 30 MPa. If the elastic modulus at 260°C is not less than the lower limit value noted above, there is obtained the effect of excelling in shape retention properties of the above-described photosensitive resin spacer when carrying out a solder reflow treatment for soldering a semiconductor device including a semiconductor element, a substrate and a photosensitive resin spacer composed of the above-described adhesive film for a photosensitive resin spacer to a substrate such as a mother board or the like. The upper limit of the elastic modulus at 260°C is not particularly limited, but it is preferably not more than 1,000 MPa and particularly preferably not more than 500 MPa. If the upper limit of the elastic modulus at 260°C is not less than the above range, reliability of the semiconductor device is deteriorated without relieving the stress applied when the semiconductor element and the substrate are jointed in some cases.
(1) Thickness of the film for a photosensitive resin spacer: 100 µm.
(2) Film for a resin spacer after an irradiation with ultraviolet rays at 700 (mj/cm²) .
(3) Measurement value: 260°C.
Here, the elastic modulus can be evaluated, for example, with a dynamic viscoelastic analyzer Rheo Stress RS150 (a product of Haake Co., Ltd.). Specifically, a resin layer having a film thickness of 50 µm (a resin layer composed of the above-described photosensitive resin composition) is formed on a polyester film having a size of 250 mm × 200 mm, and then three samples cut in a size of 30 mm × 30 mm are prepared. Respective samples are irradiated with light using a mercury lamp for pohotocuring the resin layer. The exposure dose is 700m J/cm² with light of a wavelength of 365 nm. Next, the resin layer is peeled off from the polyester film, and three of the layers are superimposed on one another and set to the above-described dynamic viscoelastic analyzer. Here, a gap between cone plates for setting samples is 100 µm (three of the above resin layers are superimposed on one another, and respective plates are pressed to be a thickness of 100 µm). The measurement conditions are a frequency of 1Hz, a temperature rise rate of 10°C/min, and a temperature range of room temperature to 300°C.

Here, the elastic modulus at 260°C refers to the elastic modulus at a temperature for carrying out a solder reflow treatment, and a solder reflow temperature becomes 260°C with the recent lead free soldering process. So, it is found that the elastic modulus at 260°C is provided within the above range, so that shape retention properties of the photosensitive resin spacer are excellent.
Meanwhile, the thickness of the film for a photosensitive resin spacer is determined to be 100 µm, because it is preferably evaluated at the same thickness as that of the resin spacer used in itself, but there is a great variation in the measurement results of the elastic modulus when the thickness of the resin spacer is thin, so that the elastic modulus is evaluated by unifying the thickness to 100 µm.
Incidentally, the elastic modulus obtained at a thickness of the actual resin spacer (the film for a photosensitive resin spacer) and the elastic modulus of the film for a photosensitive resin spacer having the above-described uniform thickness of 100 µm become substantially the same.
In addition, ultraviolet rays at 700 (mJ/cm²) are used for irradiation, because the film for a photosensitive resin spacer is fully photocured. Besides, when the thickness of the film for a photosensitive resin spacer varies, the exposure dose is suitably adjusted.

### 2. Semiconductor Device

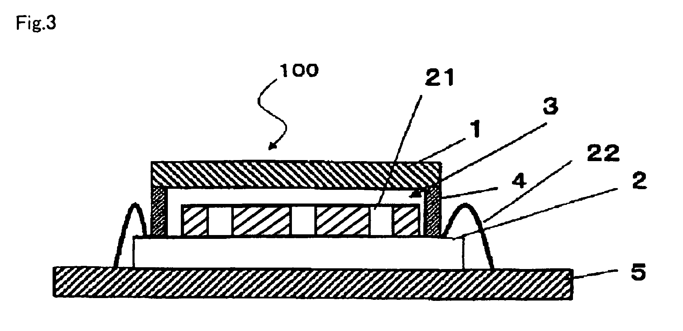

Hereinafter, the semiconductor device will be described on the basis of suitable embodiments.
The above-described film for a photosensitive resin spacer 4' is bonded to one side (on the upper side of Fig. 2a) of an interposer 5 on which a semiconductor element 2 having a light receiving section 21 is mounted.
Then, since a cavity is formed on a portion on which the semiconductor element 2 is mounted, and a mask 6 is arranged on a portion other than the portion to be the resin spacer 4 for irradiating ultraviolet rays 7 (Fig. 2b). Accordingly, the portion irradiated with ultraviolet rays 7 (the portion to be the resin spacer 4) is photocured.
Next, the developing treatment is carried out to remove the portion that is not irradiated with ultraviolet rays 7. Accordingly, the resin spacer 4 (a cavity section 3) is formed (Fig. 2c).
Subsequently, the semiconductor element 2 having the light receiving section 21 is mounted on the cavity section 3 (Fig. 2d).
Then, a functional plane of the semiconductor element 2 is connected to the terminal of the interposer 5 through a bonding wire 22 (Fig. 2d).
Then, a substrate 1 is thermally bonded to the upper end of the resin spacer 4 (upper side in Fig. 2d), whereby it is possible to obtain a semiconductor device 100 as shown in Fig. 1. Here, thermal bonding is usually carried out within a temperature range of 80 to 180°C in many cases.
The film for a photosensitive resin spacer 4' as described above is used for the semiconductor device 100 of the present invention, so that the semiconductor device 100 is excellent in patterning properties and developability in the production of the semiconductor device 100 (the photosensitive resin composition residue is suppressed), and excellent also in shape retention properties during thermal bonding of the substrate 1. That is, both developability and shape retention properties are achieved.
In addition, the semiconductor device 100 comprises the cavity section 3 which is formed at the resin spacer 4 described above, so that the thickness accuracy of the resin spacer 4 is excellent. Also, shape retention properties of the resin spacer 4 are excellent, so that reliability of the semiconductor device 100 is excellent.
Furthermore, as other embodiment of the semiconductor device, it is also possible to obtain a semiconductor device 100 as shown in Fig. 3. For the semiconductor device 100 as shown in Fig. 3, the same resin spacer 4 as described above is arranged on the outer periphery of the light receiving section 21 on the semiconductor element 2. The substrate 1 is thermally bonded on the upper part of the resin spacer 4 (upper side in Fig. 3). The substrate 1 is arranged so as to cover the light receiving section 21, but not to cover the whole semiconductor element 2. Bonding wires 22 are arranged on edges of the semiconductor element 2 (portions of the outside of the resin spacer 4), and is electrically connected to the interposer 5. According to the semiconductor device 100 as shown in Fig. 3, the semiconductor device can be much reduced in size. In addition, the light receiving section 21 is covered by the substrate 1 to have a hollow structure, so that the level of post-processing cleanliness can be reduced. In addition, in case of the semiconductor device 100 as shown in Fig. 3, the thickness of the resin spacer 4 can be thinned, and reliability can accordingly be enhanced as well.

### EXAMPLES

Hereinafter, the present invention will be illustrated in detail by way of Examples and Comparative Examples. However, the present invention is not restricted to these Examples and Comparative Examples.

### Example 1

### 1. Alkali-soluble Resin (Synthesis of a resin having an alkali-soluble group and a double bond (methacryl modified bisphenol A phenol novolac resin: MPN))

500 g of an MEK solution with a solid content of 60% of a bisphenol A novolac resin (Phenolite LF-4871, a product of Dainippon Ink and Chemicals, Inc.) was placed into a 2-liter flask. Thereto were added 1.5 g of tributylamine as a catalyst and 0.15 g of hydroquinone as a polymerization inhibitor. The flask contents were heated to 100°C. Thereto was added dropwise 180.9 g of glycidyl methacrylate for 30 minutes. The resulting mixture was stirred at 100°C for 5 hours to give rise to a reaction, whereby a methacryl modified bisphenol A novolac resin having a non-volatile content of 74% (methacryl modification rate: 50%) was obtained.

### 2. Preparation of Resin Varnish

There were weighed 65 weight % of the methacryl modified bisphenol A phenol novolac resin (MPN) synthesized above as an alkali-soluble resin, 15 weight % of polypropylene glycol diacrylate (Aronix M-225, a product of Toagosei Co., Ltd.), i.e., an acrylic resin monomer which is liquid at a room temperature, as a photopolymerizable resin, 3 weight % of a bisphenol A novolac type epoxy resin (Epiclon N-865, a product of Dainippon Ink And Chemicals, Inc.), 5 weight % of a silicon epoxy resin (BY16-115, a product of Dow Corning Toray Silicone Co., Ltd.) and 4 weight % of a phenol novolac resin (PR-53647, a product of Sumitomo Bakelite Co., Ltd.), and 6 weight % of silica (CP-102, average particle diameter: 20 nm, maximum particle diameter: 50 nm, a product of Tokuyama Corp.) as a filler. Further, methyl ethyl ketone (MEK, a product of Daishin Chemicals Corp.) was added so as to have a resin component concentration of 71%. The resulting mixture was stirred until the bisphenol A novolac type epoxy resin (N-865) was dissolved.
Subsequently, silica was dispersed by using a bead mill (bead diameter: 400 µm, processing speed: 6 g/s, five pass).
Then, 2 weight % of a curing agent (a photosensitizing agent) (Irgacure 651, a product of Ciba Specialty Chemicals Co., Ltd.) was further added and the resulting contents were stirred at 450 rpm using a stirring blade for one hour to obtain a resin varnish.

### 3. Preparation of Film for Photosensitive Resin Spacer

The above-described resin varnish was applied on a polyester film (thickness: 25 µm) and the resulting material was dried at 80°C for 15 minutes, whereby a film for a photosensitive resin spacer was obtained.

### 4. Transmittance of Film for Photosensitive Resin Spacer

The transmittances of this film for a photosensitive resin spacer at wavelengths of 400 nm, 550 nm and 750 nm were respectively 67.3%, 87.5% and 91.1%. Incidentally, the transmittances were evaluated with a UV visible spectrophotometer UV-160A manufactured by Shimadzu Corporation. Besides, the transmittances were measured at a thickness of the film for a photosensitive resin spacer of 25 µm and at measurement wavelengths of 200 to 1,000 nm, whereby the transmittances at wavelengths of 400 nm, 550 nm and 750 nm were obtained.

### 5. Tackiness of Film for Photosensitive Resin Spacer at 40°C

The tackiness of this film for a photosensitive resin spacer at 40°C was 30.5 gf. Incidentally, the tackiness at 40°C was evaluated using a tackiness measuring device, i.e., a tackiness tester model TAC-II manufactured by Rhesca Corp. Besides, the tackiness was measured at a thickness of the film for a photosensitive resin spacer of 25 µm, a stamping speed of 30 mm/min, a stamping time of 1 sec, a tensile speed of 600 mm/min, a load of 80 gf and a probe-stage temperature of 40°C, whereby the tackiness at 40°C was obtained.

### 6. Elastic Modulus of Film for Photosensitive Resin Spacer at 260°C

The elastic modulus of this film for a resin spacer after exposure to light (exposure dose: 700 mJ/cm²) at 260°C was 22.5 MPa. Incidentally, the elastic modulus was measured by superimposing three of the films for a resin spacer irradiated with light of 700 mJ/cm² at a wavelength of 365 nm using a dynamic viscoelastic analyzer Rheo Stress RS150 (measurement frequency: 1 Hz, gap distance: 100 µm, measurement temperature range: room temperature to 300°C, temperature rise rate: 10°C/min, a product of Haake Co., Ltd.), whereby the elastic modulus at 260°C was obtained.

### 7. Production of Semiconductor Device

The above-described film for a photosensitive resin spacer was laminated on a semiconductor wafer, and a resin spacer (a cavity section) was formed by exposure to light and development, whereby a glass substrate was thermally bonded to the top end of the resin spacer at 120°C. The semiconductor wafer was then diced (divided) to obtain a semiconductor device.

### Example 2

The same procedure was carried out in the same manner as in Example 1 except for using the following silica as a filler.
As silica, silica (QS-30, average particle diameter: 10 nm, maximum particle diameter: 50 nm, a product of Tokuyama Corp. ) was used. The transmittances of this film for a photosensitive resin spacer at wavelengths of 400 nm, 550 nm and 750 nm were respectively 66.8%, 87.4% and 90.5%, while the tackiness at 40°C was 31.3 gf. Further, the elastic modulus at 260°C was 23.1 MPa.

### Example 3

The same procedure was carried out in the same manner as in Example 1 except for using the following silica as a filler.
As silica, silica (QS-09, average particle diameter: 25 nm, maximum particle diameter: 50 nm, a product of Tokuyama Corp.) was used. The transmittances of this film for a photosensitive resin spacer at wavelengths of 400 nm, 550 nm and 750 nm were respectively 64.3%, 85.1% and 88.8%, while the tackiness at 40°C was 30.8 gf. Further, the elastic modulus at 260°C was 22.5 MPa.

### Example 4

The same procedure was carried out in the same manner as in Example 1, except that the amount of the methacryl modified bisphenol A phenol novolac resin (MPN) was changed from 65 weight % to 69 weight % as an alkali-soluble resin, and the amount of silica (CP-102, average particle diameter: 20 nm, maximum particle diameter: 50 nm, a product of Tokuyama Corp.) was changed from 6 weight % to 2 weight % as a filler.
The transmittances of this film for a photosensitive resin spacer at wavelengths of 400 nm, 550 nm and 750 nm were respectively 68.1%, 89.5% and 91.1%, while the tackiness at 40°C was 38.6 gf. Further, the elastic modulus at 260°C was 20.2 MPa.

### Example 5

The same procedure was carried out in the same manner as in Example 1, except that the amount of the methacryl modified bisphenol A phenol novolac resin (MPN) was changed from 65 weight % to 57 weight % as an alkali-soluble resin, and the amount of silica (CP-102, average particle diameter: 20 nm, maximum particle diameter: 50 nm, a product of Tokuyama Corp.) was changed from 6 weight % to 14 weight % as a filler.
The transmittances of this film for a photosensitive resin spacer at wavelengths of 400 nm, 550 nm and 750 nm were respectively 62.3%, 83.4% and 86.1%, while the tackiness at 40°C was 25.5 gf. Further, the elastic modulus at 260°C was 30.3 MPa.

### Example 6

The same procedure was carried out in the same manner as in Example 1, except that 65 weight % (on a solid basis) of a propylene glycol monomethyl ether solution with a solid content of 50% (Cyclomer-P ACA200M, a product of Daicel Chemical Industries, Ltd.) was used as an alkali-soluble resin, instead of 65 weight % of the methacryl modified bisphenol A phenol novolac resin (MPN) as an alkali-soluble resin.
The transmittances of this film for a photosensitive resin spacer at wavelengths of 400 nm, 550 nm and 750 nm were respectively 67.2%, 86.9% and 90.3%, while the tackiness at 40°C was 30.5 gf. Further, the elastic modulus at 260°C was 21.8 MPa.

### Example 7

The same procedure was carried out in the same manner as in Example 1, except that 15 weight % of polyethylene glycol dimethacrylate (NK Ester 3G, a product of Shin-Nakamura Chemical Co., Ltd.), i.e., an acrylic resin monomer, was used, instead of 15 weight % of polypropylene glycol diacrylate (Aronix M-225, a product of Toagosei Co., Ltd.), i.e., an acrylic resin monomer which is liquid at a room temperature, as a photopolymerizable resin.
The transmittances of this film for a photosensitive resin spacer at wavelengths of 400 nm, 550 nm and 750 nm were respectively 67.3%, 86.7% and 90.1%, while the tackiness at 40°C was 31.2 gf. Further, the elastic modulus at 260°C was 23.5 MPa.

### Comparative Example 1

The same procedure was carried out in the same manner as in Example 1 except for using the following silica as a filler.
As silica, silica (NSS-5N, average particle diameter: 70 nm, maximum particle diameter: 350 nm, a product of Tokuyama Corp.) was used. The transmittances of this film for a photosensitive resin spacer at wavelengths of 400 nm, 550 nm and 750 nm were respectively 11.3%, 48.5% and 72.1%, while the tackiness at 40°C was 46.7 gf. Further, the elastic modulus at 260°C was 15.5 MPa.

### Comparative Example 2

The same procedure was carried out in the same manner as in Example 1, except that the amount of the methacryl modified bisphenol A phenol novolac resin (MPN) was changed from 65 weight % to 70.5 weight % as an alkali-soluble resin, and the amount of silica (CP-102, average particle diameter: 20 nm, maximum particle diameter: 50 nm, a product of Tokuyama Corp.) was changed from 6 weight % to 0.5 weight % as a filler.
The transmittances of this film for a resin spacer at wavelengths of 400 nm, 550 nm and 750 nm were respectively 68.3%, 89.1% and 91.1%, while the tackiness at 40°C was 40.3 gf. Further, the elastic modulus at 260°C was 16.5 MPa.

### Comparative Example 3

The same procedure was carried out in the same manner as in Example 1, except that the amount of the methacryl modified bisphenol A phenol novolac resin (MPN) was changed from 65 weight % to 55 weight % as an alkali-soluble resin, and the amount of silica (CP-102, average particle diameter: 20 nm, maximum particle diameter: 50 nm, a product of Tokuyama Corp.) was changed from 6 weight % to 16 weight % as a filler.
The transmittances of this film for a resin spacer at wavelengths of 400 nm, 550 nm and 750 nm were respectively 60.2%, 80.1% and 82.6%, while the tackiness at 40°C was 23.2 gf. Further, the elastic modulus at 260°C was 28.5 MPa.

### Comparative Example 4

The same procedure was carried out in the same manner as in Example 1, except that the amount of the methacryl modified bisphenol A phenol novolac resin (MPN) was changed from 65 weight % to 80 weight % as an alkali-soluble resin, and the amount of polypropylene glycol diacrylate (Aronix M-225, a product of Toagosei Co. , Ltd.), i.e., an acrylic resin monomer which is liquid at a room temperature, was changed from 15 weight % to 0 weight % as a photopolymerizable resin.
The transmittances of this film for a resin spacer at wavelengths of 400 nm, 550 nm and 750 nm were respectively 67.3%, 86.6% and 90.3%, while the tackiness at 40°C was 31.0 gf. Further, the elastic modulus at 260°C was 24.2 MPa.

The films for a photosensitive resin spacer and the semiconductor devices obtained in respective Examples and Comparative Examples were evaluated in the following manner. Evaluation items are shown along with the contents. The obtained results are shown in Table 1.

### 1. Alignment Properties

A film for a photosensitive resin spacer was laminated on a semiconductor wafer (temperature: 60°C, rate: 0.3 m/min) to evaluate visibility of the pattern on the surface of the semiconductor wafer through the laminated film for a resin spacer using an exposure machine PLA-600FA (a product of Canon Inc.). The respective symbols were as defined below.
A: Even boundaries of the pattern shape vividly observed.
B: Boundaries observed somewhat indistinct although the pattern shape was identified.
C: No shape observed although the pattern was slightly identified.
D: No patterns observed.

### 2. Developability

A film for a photosensitive resin spacer was laminated on a semiconductor wafer (temperature: 60°C, rate: 0.3 m/min), exposed to light through a pattern mask to leave the photosensitive resin spacer in a lattice-shaped pattern (exposure dose: 700 mJ/cm²) , and developed in 3%TMAH (developing pressure: 0.2 MPa, developing time: 150 sec). The resulting lattice-shaped pattern was observed using an electron microscope (magnification: 5, 000) to inspect for the presence or absence of residues. The respective symbols were as defined below.
A: No residues observed.
B: No problem in practice although some residues were observed.
D: Residues observed.
In addition, a mask with a lattice-shaped pattern of a resin width of 1.2 mm and an interval of 5 mm was used.

### 3. Patterning Properties

A film for a photosensitive resin spacer was laminated on a semiconductor wafer (temperature: 60°C, rate: 0.3 m/min), exposed to light through a pattern mask to leave the resin spacer in a lattice-shaped pattern (exposure dose: 700 mJ/cm²), and developed in 3%TMAH (developing pressure: 0.2 MPa, developing time: 150 sec) for patterning to visually observe the state of patterning. The respective symbols were as defined below.
A: No pattern peeling observed.
C: Extremely small portion left with pattern observed although pattern peeling was partially observed.
D: Peeling observed all over the pattern.
In addition, a mask with a lattice-shaped pattern of a resin width of 1.2 mm and an interval of 5 mm was used.

### 4. Shape Retention Properties

The central portion of the resin spacer formed in a lattice-shaped pattern of the semiconductor wafer evaluated for the developability was diced, whereby a semiconductor element having a frame-like resin spacer was prepared. Shape retention properties were evaluated by visually observing the melt flow (degree of crushing) of the resin spacer when the glass substrate was thermally bonded to this resin spacer at 120°C. The respective symbols were as defined below.
A: No change in dimensions of the resin spacer before and after thermal bonding observed.
B: No great change in shape observed although a little melt flow of the resin spacer after thermal bonding was observed, and a little change in its dimension was observed.
C: Melt flow of the resin spacer after thermal bonding and change in its dimension observed.
D: Extremely great melt flow of the resin spacer after thermal bonding, and great changes in dimensions and shapes observed.

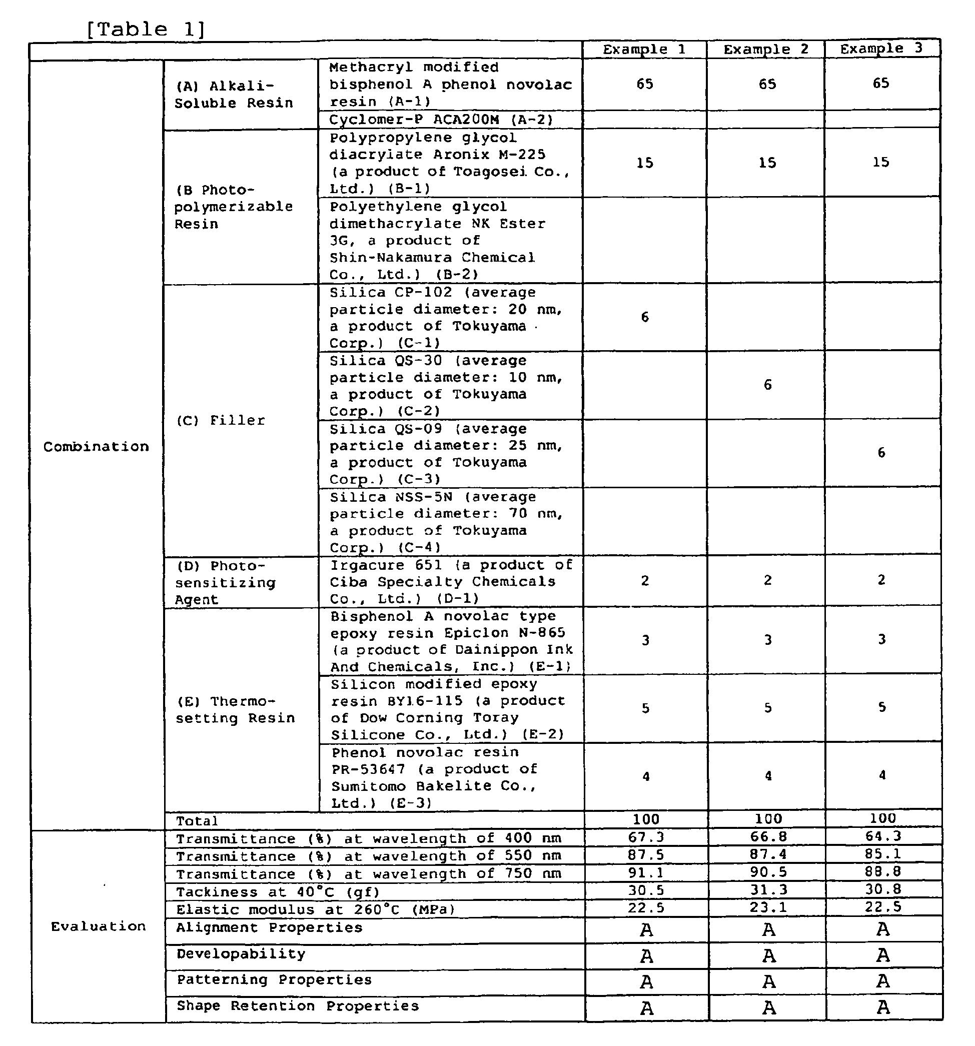

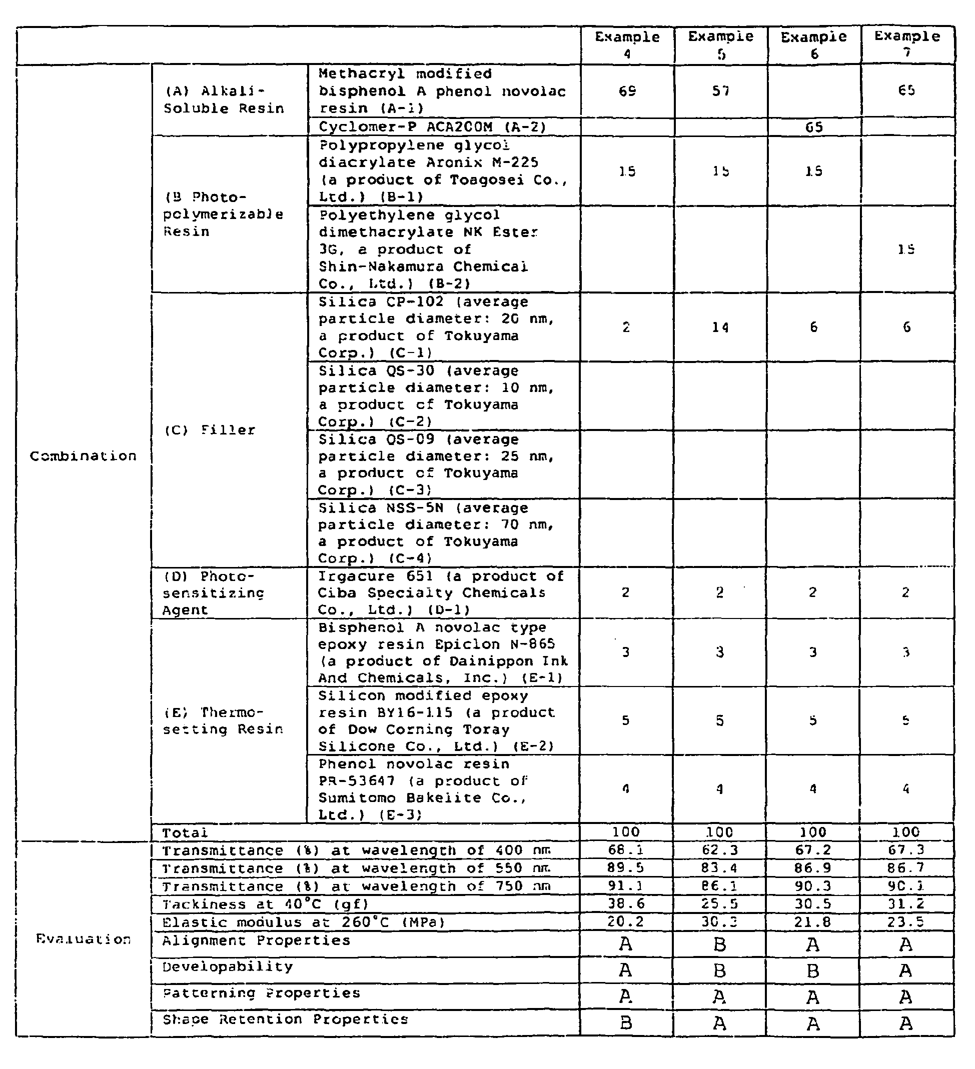

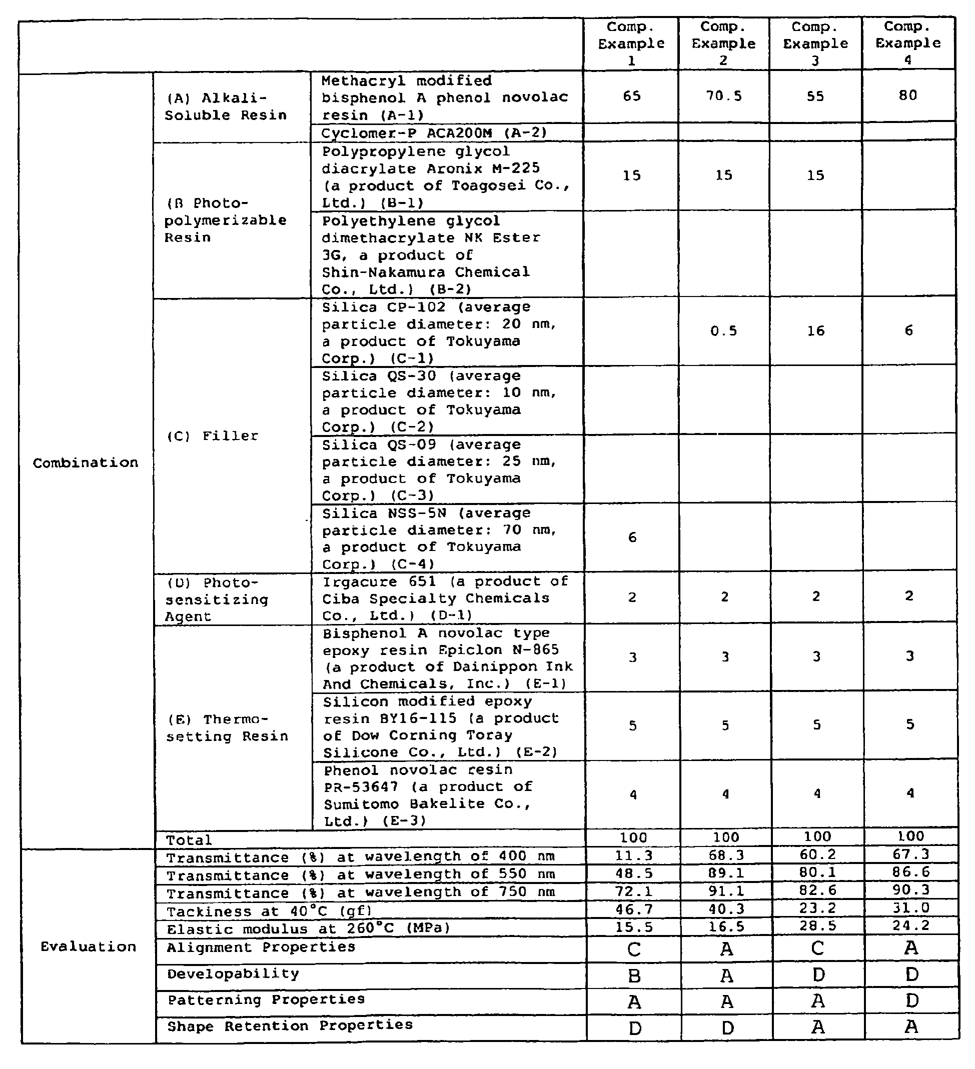

As clear from Table 1, Examples 1 to 4, 6 and 7 showed excellent alignment properties. Furthermore, Examples 1 to 4 and 7 showed excellent developability. Also, Examples 1 to 7 showed excellent patterning properties. Examples 1 to 3 and 5 to 7 showed excellent shape retention properties of the resin spacer.

Meanwhile, it was found that, in Examples of the present invention, a construction was adopted such that the average particle diameter of (C) the filler is in the range of 5 to 25 nm, and the content of (C) the above-described filler is in the range of 1 to 15 weight %, so that both developability and shape retention properties were attained.

Hereinafter, evaluation results of commercially available products (NSS-5N, a product of Tokuyama Corp., CP-102, a product of Tokuyama Corp.) will be described in detail in comparison with Examples of the present invention.
In Comparative Example 2, when the content of the filler is smaller than the range of the present invention (the content of the filler is 0.5 weight % (< 1 weight %), and the average particle diameter of the filler is 20 nm) , developability becomes excellent, but shape retention properties become deteriorated. On the other hand, in Comparative Example 3, when the content of the filler is greater than the range of the present invention (the content of the filler is 16 weight % (> 15 weight %), and the average particle diameter of the filler is 20 nm) , shape retention properties become excellent, but developability becomes deteriorated. In Comparative Examples 2 and 3, the relation between developability and shape retention properties is found such that one is excellent and the other is deteriorated.

Incidentally, in Comparative Example 1, when the average particle diameter of the filler is greater than the range of the present invention (the average particle diameter of the filler is 70 nm (> 25 nm), and the content of the filler is 6 weight %), developability becomes excellent, but shape retention properties become deteriorated. Although not shown in Comparative Examples, it is expected that, when the average particle diameter of the filler is smaller than the range of the present invention, shape retention properties become excellent, but developability becomes deteriorated.

On the other hand, in the present invention, as shown in Examples 1 to 7, the average particle diameter and the content of the filler are within the above range, so that this relation is improved and it is possible to attain excellent developability and shape retention properties at the same time.

## Claims

1. A photosensitive resin composition used as a resin spacer for forming a cavity section between a substrate and a semiconductor element, comprising:
(A) an alkali-soluble resin,
(B) a photopolymerizable resin,
(C) a filler,
(D) a photosensitizing agent, and
(E) a thermosetting resin different from said alkali-soluble resin,
wherein the average particle diameter of said filler is in the range of 5 to 25 nm and the content of said filler is in the range of 1 to 15 weight % of the total photosensitive resin composition.

2. The photosensitive resin composition according to claim 1, wherein said filler contains silica.

3. The photosensitive resin composition according to claim 1, wherein said alkali-soluble resin is a resin having an alkali-soluble group and a double bond.

4. The photosensitive resin composition according to claim 1, wherein the content of (A) said alkali-soluble resin is in the range of 50 to 95 weight % of the total photosensitive resin composition, the content of (B) said photopolymerizable resin is in the range of 5 to 45 weight % of the total photosensitive resin composition, and the content of (D) said photosensitizing agent is in the range of 0.1 to 10 weight % of the total photosensitive resin composition.

5. The photosensitive resin composition according to claim 1, wherein the content of (E) said thermosetting resin is in the range of 5 to 30 weight % of the total photosensitive resin composition.

6. A film for a photosensitive resin spacer composed of the photosensitive resin composition according to claim 1.

7. The film for a photosensitive resin spacer according to claim 6, wherein the transmittance at a wavelength of 400 nm is not less than 40%, the transmittance at a wavelength of 550 nm is not less than 65%, and the transmittance at a wavelength of 750 nm is not less than 73%.

8. The film for a photosensitive resin spacer according to claim 6, wherein the tackiness of said film for a resin spacer at 40°C is not more than 40 gf.

9. The film for a photosensitive resin spacer according to claim 6, wherein the elastic modulus of said film for a resin spacer at 260°C is not less than 20 MPa.

10. The film for a photosensitive resin spacer according to claim 6, wherein the thickness of said film for a photosensitive resin spacer is in the range of 20 to 150 µm.

11. A semiconductor device, wherein a substrate and a semiconductor element are bonded to each other through a resin spacer composed of a cured material of the photosensitive resin composition according to claim 1.

## Patentansprüche

1. Lichtempfindliche Harzzusammensetzung, die als ein Harzabstandshalter zum Ausbilden eines Hohlraumabschnitts zwischen einem Substrat und einem Halbleiterelement verwendet wird, umfassend:
(A) ein alkalilösliches Harz,
(B) ein photopolymerisierbares Harz,
(C) einen Füllstoff,
(D) ein Photosensibilisierungsmittel und
(E) ein hitzehärtbares Harz, das von dem alkalilöslichen Harz verschieden ist,
wobei der durchschnittliche Partikeldurchmesser des Füllstoffs in dem Bereich von 5 bis 25 nm liegt und der Gehalt des Füllstoffs in dem Bereich von 1 bis 15 Gew.-% der gesamten lichtempfindlichen Harzzusammensetzung liegt.

2. Lichtempfindliche Harzzusammensetzung gemäß Anspruch 1, wobei der Füllstoff Silica enthält.

3. Lichtempfindliche Harzzusammensetzung gemäß Anspruch 1, wobei das alkalilösliche Harz ein Harz mit einer alkalilöslichen Gruppe und einer Doppelbindung ist.

4. Lichtempfindliche Harzzusammensetzung gemäß Anspruch 1, wobei der Gehalt an (A) dem alkalilöslichen Harz in dem Bereich von 50 bis 95 Gew.-% der gesamten lichtempfindlichen Harzzusammensetzung liegt, der Gehalt an (B) dem photopolymerisierbaren Harz in dem Bereich von 5 bis 45 Gew.-% der gesamten lichtempfindlichen Harzzusammensetzung liegt und der Gehalt an (D) dem Photosensibilisierungsmittel in dem Bereich von 0,1 bis 10 Gew.% der gesamten lichtempfindlichen Harzzusammensetzung liegt.

5. Lichtempfindliche Harzzusammensetzung gemäß Anspruch 1, wobei der Gehalt an (E) dem hitzehärtbaren Harz in dem Bereich von 5 bis 30 Gew.-% der gesamten lichtempfindlichen Harzzusammensetzung liegt.

6. Film für einen lichtempfindlichen Harzabstandshalter, der aus der lichtempfindlichen Harzzusammensetzung gemäß Anspruch 1 zusammengesetzt ist.

7. Film für einen lichtempfindlichen Harzabstandshalter gemäß Anspruch 6, wobei die Durchlässigkeit bei einer Wellenlänge von 400 nm nicht weniger als 40% beträgt, die Durchlässigkeit bei einer Wellenlänge von 550 nm nicht weniger als 65% beträgt und die Durchlässigkeit bei einer Wellenlänge von 750 nm nicht weniger als 73% beträgt.

8. Film für einen lichtempfindlichen Harzabstandshalter gemäß Anspruch 6, wobei die Haftfähigkeit des Films für einen Harzabstandshalter bei 40°C nicht mehr als 40 gf beträgt.

9. Film für einen lichtempfindlichen Harzabstandshalter gemäß Anspruch 6, wobei der Elastizitätsmodul des Films für einen Harzabstandshalter bei 260°C nicht weniger als 20 MPa beträgt.

10. Film für einen lichtempfindlichen Harzabstandshalter gemäß Anspruch 6, wobei die Dicke des Films für einen lichtempfindlichen Harzabstandshalter in dem Bereich von 20 bis 150 µm liegt.

11. Halbleitervorrichtung, wobei ein Substrat und ein Halbleiterelement aneinander über einen Harzabstandshalter gebunden sind, der aus einem ausgehärteten Material der lichtempfindlichen Harzzusammensetzung gemäß Anspruch 1 zusammengesetzt ist.

## Revendications

1. Composition de résine photosensible utilisée comme intercalaire en résine pour former une section de cavité entre un substrat et un élément semi-conducteur, comprenant:
(A) une résine soluble dans les alcalis,
(B) une résine photopolymérisable,
(C) une charge,
(D) un agent photosensibilisant, et
(E) une résine thermodurcissable différente de ladite résine soluble dans les alcalis,
tandis que le diamètre moyen des particules de ladite charge est dans l'intervalle de 5 à 25 nm et la teneur de ladite charge est dans l'intervalle de 1 à 15 % en poids de la composition de résine photosensible totale.

2. Composition de résine photosensible selon la revendication 1, dans laquelle ladite charge contient de la silice.

3. Composition de résine photosensible selon la revendication 1, dans laquelle ladite résine soluble dans les alcalis est une résine ayant un groupe soluble dans les alcalis et une double liaison.

4. Composition de résine photosensible selon la revendication 1, dans laquelle la teneur de (A) ladite résine soluble dans les alcalis est dans l'intervalle de 50 à 95 % en poids de la composition de résine photosensible totale, la teneur de (B) ladite résine photopolymérisable est dans l'intervalle de 5 à 45 % en poids de la composition de résine photosensible totale, et la teneur de (D) ledit agent photosensibilisant est dans l'intervalle de 0,1 à 10 % en poids de la composition de résine photosensible totale.

5. Composition de résine photosensible selon la revendication 1, dans laquelle la teneur de (E) ladite résine thermodurcissable est dans l'intervalle de 5 à 30 % en poids de la composition de résine photosensible totale.

6. Film pour intercalaire en résine photosensible comprenant la composition de résine photosensible selon la revendication 1.

7. Film pour intercalaire en résine photosensible selon la revendication 6, dans lequel la transmittance à une longueur d'onde de 400 nm n'est pas inférieure à 40%, la transmittance à une longueur d'onde de 550 nm n'est pas inférieure à 65%, et la transmittance à une longueur d'onde de 750 nm n'est pas inférieure à 73%.

8. Film pour intercalaire en résine photosensible selon la revendication 6, dans lequel le pouvoir collant dudit film pour un intercalaire en résine à 40°C ne dépasse pas 40 gf.

9. Film pour intercalaire en résine photosensible selon la revendication 6, dans lequel le module élastique dudit film pour un intercalaire en résine à 260°C n'est pas inférieure à 20 MPa.

10. Film pour intercalaire en résine photosensible selon la revendication 6, dans lequel l'épaisseur dudit film pour un intercalaire en résine photosensible est dans l'intervalle de 20 à 150 µm.

11. Dispositif semi-conducteur, dans lequel un substrat et un élément semi-conducteur sont liés l'un à l'autre par l'intermédiaire d'un intercalaire en résine composé d'un matériau durci de la composition de résine photosensible selon la revendication 1.
